Europäisches Patentamt

European Patent Office

Office européen des brevets

(11) Veröffentlichungsnummer: **0 251 218**
**A2**

(19)

(12) # EUROPÄISCHE PATENTANMELDUNG

(21) Anmeldenummer: 87109163.3

(22) Anmeldetag: 25.06.87

(51) Int. Cl.⁴: **C04B 35/56** , **H01B 3/12** , **H05K 1/03**

(30) Priorität: 26.06.86 DE 3621450

(43) Veröffentlichungstag der Anmeldung:
07.01.88 Patentblatt 88/01

(84) Benannte Vertragsstaaten:
BE CH DE FR GB IT LI NL SE

(71) Anmelder: **Elektroschmelzwerk Kempten GmbH**
**Herzog-Wilhelm-Strasse 16**
**D-8000 München 2(DE)**

(72) Erfinder: **Grellner, Wolfgang, Dr.-Ing.**
**Neisserstrasse 23**
**D-8960 Kempten(DE)**
Erfinder: **Hunold, Klaus, Dr.Dipl.-Ing.**
**Hochgratweg 8**
**D-8961 Lauben(DE)**
Erfinder: **Matje, Peter, Dr. Dipl.-Ing.**
**Schwarzachen 4**
**D-8961 Wiggensbach(DE)**
Erfinder: **Mohr, Max, Dipl.Ing.**
**Gerberstrasse 33**
**D-8960 Kempten(DE)**

(54) **Elektrisch isolierende Substratwerkstoffe aus polykristallinem Siliciumcarbid und Verfahren zu ihrer Herstellung durch isostatisches Heisspressen.**

(57) Gegenstand der Erfindung sind elektrisch isolierende Substratwerkstoffe aus hochverdichtetem polykristallinem Siliciumcarbid und Zusätzen auf Oxidbasis, die im wesentlichen aus mindestens 95,0 Gew.-% Siliciumcarbid, 0,25 bis 3,5 Gew.-% Aluminiumoxid und/oder Magnesiumoxid, bis zu 0,3 Gew.-% freiem Kohlenstoff und bis zu 0,03 Gew.-% Verunreinigungen durch Elemente aus den Gruppen 3a und 5a des Periodischen Systems (vorwiegend Al + B + N) insgesamt bestehen, in welchen das SiC im wesentlichen in Form einer homogenen isotropen Mikrostruktur mit Korngrößen von maximal 5 $\mu$m vorliegt, Aluminiumoxid und/oder Magnesiumoxid überwiegend an den Korngrenzen des SiC vorhanden und als getrennte Phase(n) nachweisbar sind, mit den Eigenschaften:

Wärmeleitfähigkeit von mindestens 170 W/mK, spezifischer elektrischer Widerstand von mindestens $10^9$ Ohm.cm, thermischer Ausdehnungskoeffizient von bis zu $3,5.10^{-6}$/K und elektrische Durchschlagsfestigkeit von > 20 KV/mm.

Diese Substratwerkstoffe sind aus homogenen Pulvergemischen aus SiC mit einer Reinheit von mindestens 99,97 Gew.-% bezogen auf Verunreinigungen durch vorwiegend Al + B + N und 0,25 bis 3,5 Gew.-% Aluminiumoxid und/oder Magnesiumoxid in einer vakuumdicht geschlossenen Hülle durch isostatisches Heißpressen bei 1700° bis 2200°C und 100 bis 400 MPa unter Verwendung eines inerten Gases als Druckübertragungsmedium hergestellt worden.

## Elektrisch isolierende Substratwerkstoffe aus polykristallinem Siliciumcarbid und Verfahren zu ihrer Herstellung durch isostatisches Heißpressen

Werkstoffe aus polykristallinem Siliciumcarbid sind seit langem bekannt. Sie zeichnen sich durch eine Kombination wertvoller Eigenschaften aus, wie hohe Festigkeit, Oxidationsbeständigkeit, Thermoschockbeständigkeit, geringe thermische Ausdehnung und hohe Wärmeleitfähigkeit und können deshalb auf vielen technischen Anwendungsgebieten eingesetzt werden.

Da reines Siliciumcarbid aufgrund seiner überwiegend kovalenten Bindung sehr schlecht sinterfähig ist, können hochverdichtete Formkörper aus polykristallinem Siliciumcarbid nach den üblichen bekannten Verfahren des Heißpressens und des drucklosen Sinterns nur unter Mitverwendung von Sinterhilfsmitteln hergestellt werden. Eines der ältesten bekannten Sinterhilfsmittel ist Aluminiumoxid, das beim Heißpressen mit Verunreinigungen aus dem Siliciumcarbid eine die Verdichtung fördernde flüssige Phase bilden soll und das im fertigen Sinterkörper als getrennte Phase nachweisbar ist (vgl. F.F. Lange "Hot-pressing behaviour of silicon carbide powders with additions of aluminium oxide" in Journal of Materials Science 10 (1975), S. 314 bis 320; US-A-3 998 646).

In ähnlicher Weise soll Aluminiumoxid auch beim drucklosen Sintern zusammen mit Verunreinigungen aus dem SiC und insbesondere mit durch die umgebende Atmosphäre beim Sintern bewußt eingebrachten weiteren Hilfsstoffen, wie Aluminium-, Silicium-und/oder Kohlenstoffverbindungen, die Verdichtung von SiC unterstützen (vgl. US-A-4 354 991).

Ohne Mitverwendung von Sinterhilfsmitteln kann Siliciumcarbid indessen mit Hilfe des isostatischen Heißpressens bis zu Dichten von nahezu 100 % der theoretischen Dichte (im folgenden als % TD abgekürzt) verdichtet werden, wenn sehr reine SiC-Ausgangspulver mit einem Gesamtgehalt an metallischen Verunreinigungen von höchtens 0,1 Gew.-% verwendet werden (vgl. EP-A-71 241). Im Vergleich zu üblichen heißgepressten oder drucklos gesinterten Materialien haben derartige polykristalline SiC-Sinterkörper aufgrund ihrer Reinheit eine erheblich verbesserte Wärmeleitfähigkeit von 220 W/mK bei Raumtemperatur (vgl. K. Hunold et al. "Herstellungsverfahren und Eigenschaften von Siliciumcarbidformkörpern" in Sprechsaal, Bd. 116 (1983), S. 158 bis 162). Es ist aber auch bekannt, daß reines SiC Halbleitereigenschaften hat, dementsprechend haben diese reinen durch isostatisches Heißpressen erhaltenen Materialien einen spezifischen elektrischen Widerstand von nur etwa 100 Ohm.cm.

Damit Siliciumcarbid als Substratwerkstoff, das heißt als Trägersubstanz für den Aufbau von Mikroschaltungen und Leistungselektronikbauteilen eingesetzt werden kann, muß der elektrische Widerstand erhöht werden, um den für Isolierstoffe erforderlichen Wert von mindestens $10^7$ Ohm. cm für den spezifischen elektrischen Widerstand zu erreichen. Es hat daher nicht an Versuchen gefehlt, dem SiC durch Einbau von Hilfsstoffen elektrisch isolierende Eigenschaften zu verleihen, wobei sich insbesondere Berylliumoxid bewährt hat, das beim Heißpressen oder beim drucklosen Sintern gleichzeitig als Sinterhilfsmittel wirkt. Derartige, elektrisch isolierende Substratwerkstoffe aus SiC, die neben dem Berylliumoxid-Zusatz bis zu 0,1 Gew.-% Aluminium, bis zu 0,1 Gew.-% Bor und bis zu 0,4 Gew.-% freien Kohlenstoff enthalten können, mit einer Wärmeleitfähigkeit von mindestens 167 W/m.K sind aus der EP-B-28 802 bekannt. Hierin wurde außerdem durch Vergleichsversuche nachgewiesen, daß bei Einsatz von Aluminiumoxid anstelle von Berylliumoxid unter sonst gleichen Bedingungen (HP bei 2000°C und 30 MPa) zwar Körper mit 99 % TD und hoher mechanischer Festigkeit erhalten wurden, deren thermische Leitfähigkeit jedoch beträchtlich niedriger war (75 W/m.K) und deren spezifischer elektrischer Widerstand nur noch 10 Ohm.cm betrug. Ähnlich schlechte Ergebnisse wurden bei Einsatz von Aluminiumcarbid, Aluminiumnitrid und Aluminiumphosphat erzielt.

Anstelle von Berylliumoxid per se können auch Berylliumverbindungen verwendet werden (vgl. EP-A-64 264) oder Borverbindungen, wie Bornitrid und zweckmäßig weiteren Hilfsstoffen zur Unterstützung der Sinterfähigkeit des SiC (vgl. EP-A-81 365). Hierin wurde wieder durch Vergleichsversuche nachgewiesen,- (HP bei 2000°C und 27 MPa), daß bei Einsatz von Aluminiumoxid und Berylliumoxid (1 Gew.-% Al₂O₃ + 1 Gew.-% BeO) nur eine Wärmeleitfähigkeit von 84 W/mK erzielt wurde und bei Einsatz von MgO allein (2 Gew.-%) war der Körper nicht dicht (55 % TD).

Durch Erniedrigung des Stickstoffgehalts auf nicht mehr als 500 ppm in der Pulvermischung aus SiC + Berylliumverbindungen soll außerdem erreicht werden, daß auch bei größeren Körpern kein Abfall der gewünschten Eigenschaften auftritt (vgl. EP-A-107 821).

Um den Einsatz der hochtoxischen Berylliumverbindunen auszuschließen, wurden ferner Aluminiumnitrid allein (gleich oder < 10 Gew.-%) oder Gemische aus Aluminiumnitrid und Bornitrid (5 - 15 Gew.-%) verwendet. Hiermit konnten zwar ausreichende Isoliereigenschaften des SiC erreicht werden, aber nur Wärmeleitfähigkeitswerte von < 100 W/mK (vgl. JP 59 54 289, ref. in C.A. 101:15 976 a und JP 59 111 978, ref. in CA 101:19 69 30z).

Auch Mischkeramiken aus SiC und AlN mit Zusätzen von Calcium-, Barium-oder Strontiumoxid (0,1 bis 3 Gew.-%) brachten nur wenig bessere Ergebnisse in Bezug auf die Wärmeleitfähigkeit (vgl. EP-A-80 213).

Da die Entwicklung der Elektronik in den letzten Jahren zu einer immer stärkeren Miniaturisierung der Bauteile geführt hat, das heißt Entwicklung sogenannter Megabit-Chips, sind selbstverständlich auch die Anforderungen an die Substratwerkstoffe gestiegen, die nicht nur einen hohen spezifischen elektrischen Widerstand, sondern auch eine hohe Wärmeleitfähigkeit haben müssen, die beim SiC bisher nur mit Berylliumverbindungen erreicht werden konnte. Gegenüber anderen für diesen Verwendungszweck in Frage kommenden Isolierwerkstoffen, wie Aluminiumoxid hat Siliciumcarbid den Vorteil einer höheren mechanischen Festigkeit (Biegebruchfestigkeit von mindestens 500 N/mm² bei Raumtemperatur) und eines Wärmeausdehnungskoeffizienten ähnlich dem von Silicium (ungefähr $3,3 \times 10^{-6}/°C$).

Es stellt sich somit die Aufgabe, elektrisch isolierende Substratwerkstoffe aus hochverdichtetem polykristallinem Siliciumcarbid zur Verfügung zu stellen, die diese Anforderungen ohne die Mitverwendung hochtoxischer Verbindungen erfüllen.

Diese Aufgabe wird erfindungsgemäß durch elektrisch isolierende Substratwerkstoffe aus polykristallinem Siliciumcarbid und Zusätzen auf Oxidbasis mit einer Dichte von mindestens 99,8 % TD, bezogen auf die theoretische mögliche Dichte von reinem SiC gelöst, die im wesentlichen aus

| mindestens | | 95,0 | Gew.-% | Siliciumcarbid |
|---|---|---|---|---|
| | 0,25 - | 3,5 | Gew.-% | Aluminiumoxid und/oder Magnesiumoxid, |
| bis zu | | 0,3 | Gew.-% | freiem Kohlenstoff und |
| bis zu | | 0,03 | Gew.-% | Verunreinigungen durch |

Elemente aus den Gruppen 3a und 5a der Periodischen Systems (vorwiegend Al + B + N) insgesamt bestehen, in welchen das Siliciumcarbid im wesentlichen in Form einer homogenen isotropen Mikrostruktur mit Korngrößen von maximal 5 μm vorliegt, Aluminiumoxid und/oder Magnesiumoxid überwiegend an den Korngrenzen des Siliciumcarbid vorhanden und als getrennte Phase(n) nachweisbar sind und die folgende Eigenschaften haben:

Wärmeleitfähigkeit bei 300 K von mindestens 170 W/mK spezifischer elektrischer Widerstand bei 300 K von mindestens 10⁹ Ohm.cm

thermischer Ausdehnungskoeffizient von bis zu $3,5 \times 10^{-6}/K$ im Bereich von 20°C bis 300°C und elektrische Durchschlagsfestigkeit von größer als 20 kV/mm.

Die erfindungsgemäßen Substratwerkstoffe sind aus homogenen Pulvergemischen aus Siliciumcarbid mit einer Reinheit von mindestens 99,97 Gew.-%, bezogen auf Verunreinigungen durch Elemente aus den Gruppen 3a und 5a der Periodischen Systems (vorwiegend Al + B + N) insgesamt und 0,25 bis 3,5 Gew.-% Aluminiumoxid und/oder Magnesiumoxid in einer vakuumdicht geschlossenen Hülle durch isostatisches Heißpressen bei einer Temperatur von 1700° bis 2200°C und einem Druck von 100 bis 400 MPa im Hochdruckautoklaven unter Verwendung eines inerten Gases als Druckübertragungsmedium hergestellt worden.

Da während des isostatischen Heißpressvorgangs durch die vorhandene vakuumdicht geschlossene Hülle nichts entweichen kann, haben die erfindungsgemäßen Substratwerkstoffe mit einer Dichte von mindestens 99,8 % TD, vorzugsweise 100 % TD dieselbe chemische Zusammensetzung wie die Ausgangspulvergemische. Es ist daher von entscheidender Bedeutung, daß von sehr reinen Ausgangspulvern ausgegangen wird, damit im fertigen Substratwerkstoff die angegebenen Mengen von bis zu 0,3 Gew.-% freiem Kohlenstoff und bis zu 0,03 Gew.-% Verunreinigungen durch Elemente aus den Gruppen 3a und 5a des Periodi schen Systems, worunter vorwiegend Al + B + N insgesamt zu verstehen sind, nicht überschritten werden.

Die erfindungsgemäßen Substratwerkstoffe bestehen überwiegend aus polykristallinem Siliciumcarbid und sie haben definitionsgemäß eine isotrope Mikrostruktur in der die einzelnen SiC-Körner mit Korngrößen von maximal 5 μm homogen und richtungsunabhängig verteilt sind, während Aluminiumoxid und/oder Magnesiumoxid überwiegend an den Korngrenzen der SiC-Körner vorhanden sind, sodaß sie durch röntgenographische Phasenanalyse bzw. keramographisch als getrennte Phase oder Phasen nachgewiesen werden können.

Für die Herstellung der erfindungsgemäßen Substratwerkstoffe werden als Ausgangsmaterialien vorteilhaft feine Pulver aus alpha-oder beta-SiC oder Gemische aus alpha-und beta -SiC mit einer Teilchengröße von 5 μm und feiner, entsprechend einer spezifischen Oberfläche von 4 bis 40 m²/g, vorzugsweise von 5 - 20 m²/g (gemessen nach BET) und einer Reinheit von definitionsgemäß mindestens 99,97 Gew.-%, bezogen auf die Verunreinigungen durch Elemente aus den Gruppen 3a und 5a des Periodischen Systems insgesamt, verwendet. Unter diesen Verunreinigungen sind insbesondere die Elemente Al, B und N zu verstehen, welche insgesamt den angegebenen Wert von 0,03 Gew.-% nicht überschreiten sollen. Vorzugsweise soll der Gehalt an Al + B + N in den SiC-Pulvern weniger als 0,025 Gew.-% betragen. Die besten Ergebnisse werden mit einem Gehalt an Al + B + N von weniger als 0,0095 Gew.-% erzielt. Es wurde nachgewiesen, daß bei Einsatz von SiC-Pulver mit einem Gehalt von Al + B + N von etwa 0,06 Gew.-% der spezifische elektrische Widerstand in den fertigen Substratwerkstoffen auf $10^5$ Ohm.cm abgesunken war. Anhaftender Kohlenstoff, der von der Herstellung her in den SiC-Pulvern vorhanden sein kann, beträgt vorteilhaft weniger als 0,3 Gew.-% und insbesondere wenger als 0,2 Gew.-%. In den SiC-Pulvern vorhandener Sauerstoff, der üblicherweise vorwiegend in Form von anhaftendem $SiO_2$ vorliegt, das aufgrund der bekannten Oxidationsneigung des SiC beim Mahlvorgang gebildet wird, stört indessen nicht und kann daher bis zu höchstens 0,6 Gew.-% toleriert werden, vorzugsweise soll der Sauerstoffgehalt jedoch weniger als 0,5 Gew.-% betragen.

Als Zusätze werden Sauerstoff enthaltende Aluminium-oder Magnesiumverbindungen oder Gemische hiervon verwendet, die entweder bereits als Oxid oder Mischoxid vorliegen, wie $Al_2O_3$, MgO und Spinell oder die in situ Oxide bilden, wie $MgCO_3$. Diese Zusätze müssen ebenfalls sehr rein sein und sollten etwa die gleiche Teilchengröße wie die verwendeten SiC-Pulver haben. Diese Zusätze werden in den definierten Mengen von 0,25 bis 3,5, vorzugsweise von 1 bis 3 Gewichtsprozent berechnet als Oxid, bzw. als Oxide, mit dem SiC-Pulver homogen vermischt. Anschließend werden diese homogenen Ausgangspulvergemische durch Formgebung unter Bildung von vorgeformten Grünkörpern kompaktiert. Für die Formgebung können die Ausgangspulvergemische zusammen mit einem temporären Bindemittel vermischt oder in einer Lösung des temporären Bindemittels in einem organischen Lösungsmittel dispergiert werden. Als organische Lösungmittel können beispielsweise Aceton oder niedere aliphatische Alkohole mit 1 bis 6 C-Atomen verwendet werden. Beispiele für temporäre Bindemittel sind Polyvinylalkohol, Stearinsäure, Polyethylenglykol oder Campher, die in Mengen bis zu etwa 5 Gew.-%, vorzugsweise bis zu etwa 3 Gew.-%, bezogen auf das Gesamtgewicht der Pulvermischung verwendet werden können. Die Mitverwendung des temporären Bindemittels ist jedoch nicht unbedingt erforderlich. Die Formgebung kann durch übliche bekannte Maßnahmen, beispielsweise durch Gesenkpressen, isostatisches Pressen, Spritzgießen, Strangpressen, Schlickergießen oder Foliengießen bei Raumtemperatur oder bei erhöhter Temperatur vorgenommen werden. Nach der Formgebung sollten die Grünkörper eine theoretische Dichte von mindestens 50 % , vorzugsweise mindestens 60 % TD aufweisen, das heißt, die Grünkörper sind porös mit offener Porosität, worunter zu verstehen ist, daß sie zur Oberfläche offene Poren oder Kanalporen haben. Anschließend werden die Grünkörper vorteilhaft einer thermischen Behandlung durch Erhitzen auf 300° bis 1200°C unterzogen, bevor sie mit der gasdichten Hülle versehen werden, um sicherzustellen, daß bei der heißisostatischen Verdichtung keine Zersetzungsprodukte aus den Bindemitteln oder Zusätzen den Verdichtungsvorgang stören oder die Hülle beschädigen.

Die Herstellung der erfindungsgemäßen Substratwerkstoffe erfolgt definitionsgemäß durch isostatisches Heißpressen der vorgeformten Grünkörper aus homogenen Ausgangspulvergemischen in einer vakuumdicht geschlossenen Hülle bei einer Temperatur von 1700° bis 2200°C und einem Druck von 100 bis 400 MPa im Hochdruckautoklaven unter Verwendung eines inerten Gases als Druckübertragungsmedium. Für die Druchführung dieses Verfahrens müssen die vorgeformten Grünkörper mit einer gasdichten Hülle versehen werden, bevor sie in den Hochdruckautoklaven eingebracht werden, um zu vermeiden, daß das als Druckübertragungsmedium verwendete Gas durch die offenen Poren in den Körper eindringt und dadurch die Verdichtung stört.

Als Materialien für diese gasdicht verschließbaren Hüllen sind selbstverständlich nur solche brauchbar, die bei den angewendeten Presstemperaturen im Bereich von 1700° bis 2200°C weder schmelzen noch mit den Grünkörpern reagieren, das heißt sie müssen sich diesen gegenüber vollkommen inert verhalten. Sie müssen bei den angewendeten Presstemperaturen hinreichend plastisch sein und sich der Form des

4

Körpers genau anpassen, ohne zu reißen, um sicherzustellen, daß der Gasdruck gleichmäßig über die Hülle auf die Körper übertragen wird. Beispiele für geeignete Hüllmaterialien, die diesen Anforderungen genügen, sind hochschmelzende Gläser, wie reines Quarzglas oder hochschmelzende Keramikarten. Diese Materialien können in Form von vorgefertigten Hüllen oder Kapseln verwendet werden, in welche die Grünkörper eingebracht werden.

Dann werden die Hüllen samt Inhalt evakuiert und gasdicht verschlossen. Die Hüllen können jedoch auch auf den Grünkörpern durch direkte Beschichtung erzeugt werden, beispielsweise durch Aufbringen einer glas-oder keramikartigen Masse, die anschließend im Vakuum unter Bildung der gasdichten Hülle geschmolzen oder gesintert wird. Unter dem Ausdruck "vakuumdicht geschlossene Hülle" ist zu verstehen, daß die Hülle undurchlässig gegenüber dem von außen einwirkenden Druckgas ist und daß innerhalb der Hülle keine eingeschlossenen Restgase vorhanden sind, die den Verdichtungsvorgang stören.

Die mit vakuumdicht verschlossenen Hüllen versehenen Körper werden vorteilhaft in Graphitbehältern untergebracht,die dann in den Hochdruckautoklaven eingebracht und auf die erfoderliche Verdichtungstemperatur von mindestens 1700°C erhitzt werden. Hierbei ist es vorteilhaft, Druck und Temperatur getrennt zu regeln, das heißt, den Gasdruck erst dann zu erhöhen, wenn das Hüllmaterial anfängt sich unter dem Druck plastisch zu verformen. Als inerte Gase für die Druckübertragung werden vorzugsweise Argon oder Stickstoff verwendet. Der angewendete Gasdruck liegt vorzugsweise im Bereich von 150 bis 250 MPa der unter langsamer Erhöhung bei der angewendeten Endtemperatur erreicht wird, die vorzugsweise im Bereich von 1800° bis 1950°C liegt. Die jeweils optimale Temperatur ist abhängig von der Feinheit und Reinheit des verwendeten SiC-Ausgangspulvers und sollte nicht überschritten werden, weil sonst die Gefahr besteht, daß die gebildeten, praktisch porenfreien Substratwerkstoffe eine sogenannte "sekundär rekristallisierte Mikrostruktur" aufweisen, die nicht mehr homogen ist, weil einige Körner stärker als die übrigen gewachsen sind, was sich insbesondere nachteilig auf die Wärmeleitfähigkeit auswirkt.

Nach Erniedrigung von Druck und Temperatur werden die abgekühlten Substratwerkstoffe aus dem Hochdruckautoklaven entnommen und von den Hüllen befreit, beispielsweise durch Sand strahlbehandlung der Glas-oder Keramikhüllen.

Die so hergestellten Substratwerkstoffe sind nicht nur praktisch porenfrei mit einer Dichte von mindestens 99,8 % TD, sondern sie sind aufgrund der allseitigen Druckanwendung auch praktisch texturfrei, das heißt, sie haben eine isotrope Mikrostruktur, sodaß ihre Eigenschaften nicht mehr richtungsabhängig, sondern in allen Richtungen gleichbleibend sind.

Da die Verdichtung mit Hilfe des isostatischen Heißpressens bei relativ niedriger Temperatur erfolgt, die im allgemeinen bis zu etwa 100°C niedriger ist, als beim konventionellen Heißpressen, findet nur ein äußerst geringes Kornwachstum statt und die Aluminiumoxid-bzw. Magnesiumoxidzusätze bleiben überwiegend an den Korngrenzen des SiC erhalten. Die feinkörnige Mikrostruktur im fertigen Substratwerkstoff entspricht somit praktisch weitgehend der Kornverteilung im Ausgangspulvergemisch. Da außerdem durch die hohe Reinheit der Ausgangspulver der Einbau von Fremdatomen in das SiC-Gitter, welche die elektrische Leitfähigkeit erhöhen (Al, B und N) entsprechend gering ist, haben die erfindungsgemäßen Substratwerkstoffe ausgezeichnete elektrische Isoliereigenschaften, die ausgedrückt als spezifischer elektrischer Widerstand bei 300 K Werte von bis zu $>10^{13}$ Ohm.cm erreichen und Wärmeleitfähigkeitwerte bei 300 K von bis zu 260 W/mK.

Darüberhinaus haben die erfindungsgemäßen Substratwerkstoffe aufgrund der hohen Dichte und der feinkörnigen isotropen Mikrostruktur eine hohe mechanische Festigkeit, die ausgedrückt als Biegefestigkeit, gemessen nach der 4-Punkt-Methode bei Raumtemperatur Werte von mindestens 500 N/mm² erreicht und thermische Ausdehnungskoeffizienten von 3,3 bis $3,4.10^{-6}$ K im Bereich von RT bis 300°C.

Daß diese Kombination von Eigenschaften, nämlich hohe Dichte, hohes elektrisches Isoliervermögen und hohe Wärmeleitfähigkeit, welche die erfindungsgemäßen Substratwerkstoffe charakterisiert durch den Zusatz von Aluminiumoxid und/oder Magnesiumoxid zu den hochreinen SiC-Ausgangspulvern mit Hilfe des isostatischen Heißpressens erreicht werden konnte, muß im Hinblick auf den Stand der Technik als überraschend bewertet werden, nachdem bekannt war, daß weniger reine SiC-Ausgangspulver mit Hilfe des konventionellen Heißpressens durch Zusatz von Aluminiumoxid allein zwar hochverdichtet werden konnten, die fertigen Werkstoffe jedoch nicht mehr elektrisch isolierend waren und eine geringere Wärmeleitfähigkeit hatten und durch Zusatz von Magnesiumoxid allein nur mehr äußerst mangelhaft verdichtet werden konnten.

In den folgenden Beispielen wird der Erfindungsgegenstand näher erläutert.

Beispiel 1 bis 9 (erfindungsgemäß):

Als Ausgangsmaterial wurde ein alpha-SiC-Pulver mit einer spezifischen Oberfläche (gemessen nach BET) von 12,5 m²/g und folgender Analyse verwendet:

|  | Gew.-% |
|---|---|
| $C_{gesamt}$ | 29.97 |
| $C_{frei}$ | 0.18 |
| O | 0.3 |
| Al | 0.0040 |
| B | 0.0017 |
| N | 0.0035 |
| Fe | 0.0090 |
| Ca | 0.0020 |
| $Si_{frei}$ | nicht erfaßbar |

Dieses SiC-Pulver wurde mit feindispersem Aluminiumoxid-und/oder Magnesiumcarbonatpulver in den angegebenen Mengen durch Rühren in Aceton homogen vermischt. Kurz vor Beendigung des Mischvorganges wurden 2,0 Gew.-% Campher als Bindemittel eingearbeitet. Anschließend wurde das Lösungsmittel entfernt und das erhaltene Pulvergemisch trocken zu zylinderförmigen Grünkörpern verpresst. Diese Grünkörper wurden in vorgefertigte Quarzglashüllen eingebracht. Dann wurden die Hüllen samt Inhalt evakuiert, das Bindemittel bei leicht erhöhter Temperatur entfernt und anschließend die Hüllen durch Zuschmelzen gasdicht verschlossen. Die gehüllten Proben wurden im Hochdruckautoklaven und einem Argongasdruck von 200 MPa bei 1950°C und einer Haltezeit bei dieser Temperatur von 30 Minuten heißisostatisch verdichtet. Nach Dekompression und Abkühlen der Formkörper auf Raumtemperatur wurden die Proben aus der HIP-Anlage entnommen und die Glashüllen durch Abschlagen und Sandstrahlen entfernt. Die so hergestellten Formkörper hatten eine Dichte von jeweils mehr als 99,8 % TD. Von diesen Formkörpern wurden durch Planschleifen Prüfkörper für die Bestimmung der Wärmeleitfähigkeit, des spezifischen elektrischen Widerstands und der Biegebruchfestigkeit hergestellt.

Die Bestimmung der Wärmeleitfähigkeit erfolgte nach der Vergleichstabmethode stationär bis 927°C unter Verwendung von Armco-Eisen als Referenzmaterial. Der spezifische elektrische Widerstand wurde bei Raumtemperatur (25°C) mit Gleichstrom nach der 3-Punkt-Meßmethode bestimmt. Die Biegebruchfestigkeit wurde nach der 4-Punkt-Methode bei Auflageabständen von 15 mm (oberer) und 30 mm (unterer) bei Raumtemperatur gemessen. Außerdem wurde der thermische Ausdehnungskoeffizient bestimmt.

In der folgenden Tabelle 1 sind Art und Menge der Zusätze, jeweils berechnet als Oxid, und die Meßdaten der Formkörper zusammengestellt.

## Tabelle 1

| Beispiel Nr. | Zusätze in Gew.-% $Al_2O_3$ | MgO | B B F in $N/mm^2$ | W L F in W/mK | elektr. Widerst. in Ohm.cm | therm. AK in $10^{-6}$/K |
|---|---|---|---|---|---|---|
| 1 | 0.3 | – | 620 | 190 | $10^{12}$ | 3.3 |
| 2 | 0.5 | – | 600 | 240 | $> 10^{13}$ | 3.3 |
| 3 | 1.0 | – | 530 | 260 | $> 10^{13}$ | 3.3 |
| 4 | 3.0 | – | 500 | 205 | $10^{11}$ | 3.4 |
| 5 | – | 0.5 | 600 | 180 | $10^{10}$ | 3.3 |
| 6 | – | 1.0 | 500 | 170 | $10^{12}$ | 3.4 |
| 7 | – | 3.0 | 470 | 170 | $10^{9}$ | 3.4 |
| 8 | 0.3 | 0.3 | 550 | 190 | $10^{13}$ | 3.3 |
| 9 | 1.0 | 0.5 | 500 | 170 | $10^{11}$ | 3.4 |

B B F = Biegebruchfestigkeit

W L F = Wärmeleitfähigkeit

elektr. Widerst. = spezifischer elektrischer Widerstand

therm. AK = thermischer Ausdehnungskoeffizient

Beispiel 10 bis 13 (zum Vergleich):

Als Ausgangsmaterial wurden alpha-SiC-Pulver mit höheren Gehalten an Verunreinigungen (Al + B + N) verwendet, die zusammen mit jeweils 0,5 Gew.-% Aluminiumoxid verarbeitet wurden. Aus diesen Pulvergemischen wurden Formkörper hergestellt durch

a) isostatisches Heißpressen (HIP) unter den gleichen Bedingungen wie in Beispiel 1 angegeben (Temperatur 1950°C; Druck 200 MPa; Haltezeit 30 Minuten) und

b) konventionelles Heißpressen (HP) in Graphitformen

(Temperatur 2000°C; Druck 30 MPa; Haltezeit 60 Minuten). Dann wurde von den so erhaltenen Formkörpern die elektrische Leitfähigkeit und der spezifische elektrische Widerstand bestimmt. In der folgenden Tabelle 2 sind der Gehalt an Verunreinigungen (Al + B + N) im alpha-SiC-Ausgangspulver und die Meßdaten der daraus gemäß a) und b) hergestellten Formkörper zusammengestellt.

## Tabelle 2

### Beispiel-Nr.

| $\alpha$ –SiC-Pulver | 10 | 11 | 12 | 13 |
|---|---|---|---|---|
| Gew.-% Al | 0.0110 | 0.0420 | 0.0830 | 0.0048 |
| "  B | 0.0035 | 0.0065 | 0.0095 | 0.0350 |
| "  N | 0.0250 | 0.0175 | 0.0235 | 0.0065 |
| "  Sa: Al + B + N | 0.0395 | 0.0660 | 0.1160 | 0.0463 |
| Formkörper Herst. a) HIP | | | | |
| WLF in W/mK | 155 | 165 | 145 | 98 |
| el. Widerst. in Ohm.cm | $10^7$ | $10^5$ | $5 . 10^6$ | $10^6$ |
| Formkörper Herst. b) HP | | | | |
| WLF in W/mK | 105 | 95 | 90 | 85 |
| el. Widerst. in Ohm.cm | $10^3$ | $10^3$ | $10^3$ | $10^5$ |

Die Meßdaten in Tabelle 2 zeigen deutlich den Einfluß des Gehalts an Verunreinigungen (Al + B + N) im SiC-Ausgangspulver auf die Wärmeleitfähigkeit und den spezifischen elektrischen Widerstand der daraus hergestellten Formkörper, die sich mit zunehmendem Gehalt an diesen Verunreinigungen verschlechtern. Sie zeigen außerdem den Einfluß des Herstellungsverfahrens, da die aus SiC-Pulver mit jeweils gleichem Gehalt an Verunreinigungen durch konventionelles Heißpressen (HP) hergestellten Formkörper noch schlechtere Werte für die Wärmeleitfähigkeit und den spezifischen elektrischen Widerstand hatten, als die durch isostatisches Heißpressen (HIP) hergestellten Formkörper.

**Ansprüche**

1. Elektrisch isolierende Substratwerkstoffe aus polykristallinem Siliciumcarbid und Zusätzen auf Oxidbasis mit einer Dichte von mindestens 99,8 % TD, bezogen auf die theoretisch mögliche Dichte von reinem SiC,
**dadurch gekennzeichnet,**
daß sie im wesentlichen aus

```
mindestens          95.0  Gew.-%  Siliciumcarbid,
              0.25 bis  3.5  Gew.-%  Aluminiumoxid und/oder
                                     Magnesiumoxid,
    bis zu            0.3  Gew.-%  freiem Kohlenstoff und
    bis zu            0.03 Gew.-%  Verunreinigungen durch
```

Elemente aus den Gruppen 3a und 5a des Periodischen Systems (vorwiegend Al + B + N) insgesamt bestehen,

in welchen das Siliciumcarbid im wesentlichen in Form einer homogenen, isotropen Mikrostruktur mit Korngrößen von maximal 5 μm vorliegt, Aluminiumoxid und/oder Magnesiumoxid überwiegend an den Korngrenzen des Siliciumcarbids vorhanden und als getrennte Phase(n) nachweisbar sind, mit den Eigenschaften:

Wärmeleitfähigkeit bei 300 K von mindestens 170 W/mK, spezifischer elektrischer Widerstand bei 300 K von mindesten $10^9$ Ohm.cm,

thermischer Ausdehnungskoeffizient von bis zu 3.5 $\times$ $10^{-6}$/K im Bereich von 20° bis 300°C und

elektrische Durchschlagsfestigkeit von größer als 20 kV/mm.

2. Elektrisch isolierende Substratwerkstoffe gemäß Anspruch 1,

**dadurch gekennzeichnet,**

daß sie aus homogenen Pulvergemischen aus Siliciumcarbid mit einer Reinheit von mindestens 99.97 % Gew.-%, bezogen auf Verunreinigungen durch Elemente aus den Gruppen 3a und 5a des Periodischen Systems (vorwiegend Al + B + N) insgesamt und 0.25 bis 3.5 Gew.-% Aluminiumoxid und/oder Magnesiumoxid in einer vakuumdicht geschlossenen Hülle durch isostatisches Heißpressen bei einer Temperatur von 1700° bis 2200°C und einem Druck von 100 bis 400 MPa im Hochdruckautoklaven unter Verwendung eines inerten Gases als Druckübertragungsmedium hergestellt worden sind.

3. Verfahren zur Herstellung der elektrisch isolierenden Substratwerkstoffe gemäß Anspruch 1 und 2 durch isostatisches Heißpressen im Hochdruckautoklaven unter Verwendung eines inerten Gases als Druckübertragungsmedium,

**dadurch gekennzeichnet ,**

daß Siliciumcarbidpulver mit einer Teilchengröße von 5μm und feiner und mit einer Reinheit von mindestens 99.97 Gew.-%, bezogen auf Verunreinigungen durch Elemente aus den Gruppen 3a und 5a des Periodischen Systems (vorwiegend Al + B + N) insgesamt, mit 0.25 bis 3.5 Gew.-% einer Sauerstoff enthaltenden Aluminium-oder Magnesiumverbindung oder Gemischen hiervon, berechnet als Oxid, bzw. Oxide, homogen vermischt, die homogenen Ausgangspulvergemische durch Formgebung unter Bildung vorgeformter Grünkörper mit einer Dichte von mindestens 50 % TD kompaktiert, die vorgeformten Grünkörper in vorgefertigte Hüllen aus hochschmelzendem Glas oder Keramik eingesetzt oder mit einem eine vakuumdichte Hülle bildenden Material aus hochschmelzendem Glas oder Keramik beschichtet, die Hüllen vakuumdicht geschlossen, dann die mit den vakuumdicht geschlossenen Hüllen versehenen Grünkörper in den Hochdruckautoklaven eingebracht und auf 1700° bis 2200°C erhitzt unter langsamer Erhöhung des Gasdruckes auf 100 bis 400 MPa durch das als Druckübertragungsmedium verwendete Gas, bis zur Bildung der praktisch porenfreien Substratwerkstoffe mit einer Dichte von mindestens 99.8 Gew.-% TD und mit gleicher chemischer Zusammensetzung wie die Ausgangspulvergemische, diese Substratwerkstoffe nach dem Abkühlen aus dem Hochdruckautoklaven entnommen und von den Hüllen befreit werden.